# EUROPEAN PATENT SPECIFICATION

(11) **EP 0 767 602 B1**
(45) Date of publication and mention of the grant of the patent: **07.04.2004**
(21) Application number: 96115983.7
(22) Date of filing: 04.10.1996
(51) Int. Cl.: H05K 13/04

(54) **Method and apparatus for mounting a part**
Methode und Vorrichtung zum Montieren von Bauelementen
Méthode et appareil pour monter un composant

(30) Priority: 04.10.1995 JP 25792495
(43) Date of publication of application: 09.04.1997
(73) Proprietor: YAMAHA HATSUDOKI KABUSHIKI KAISHA, Iwata-shi Shizuoka-ken, 438 (JP)
(72) Inventor: Togami, Tsuneji, Yamaha Hatsudoki K.K., Iwata-shi, Shizuoka-ken (JP); Iwatsuka, Yoshihisa, Yamaha Hatsudoki K.K., Iwata-shi, Shizuoka-ken (JP)
(74) Representative: Grünecker, Kinkeldey, Stockmair & Schwanhäusser Anwaltssozietät

(56) References cited:
- GB-A- 2 173 426
- US-A- 5 203 061
- PATENT ABSTRACTS OF JAPAN vol. 95, no. 8, 29 September 1995 & JP 07 124824 A (SANYO ELECTRIC CO LTD), 16 May 1995,
- PATENT ABSTRACTS OF JAPAN vol. 95, no. 4, 31 May 1995 & JP 07 030292 A (YAMAHA MOTOR CO LTD), 31 January 1995,
- PATENT ABSTRACTS OF JAPAN vol. 16, no. 271 (E-1218), 18 June 1992 & JP 04 064283 A (MATSUSHITA ELECTRIC IND CO), 28 February 1992,

## Description

This invention relates to a method of mounting a part at a specific position, in particular, mounting an electronic part onto a substrate such as a printed circuit board with an apparatus, said apparatus comprising first and second head units being at least horizontally movable along first and second axes being perpendicular to each other, first and second part feeding sections being arranged at both sides of said first axis, and a holding mechanism for holding for example said printed circuit board, comprising the steps of moving the respective head units to the respective part feeding section, picking up the part to be mounted, moving the respective head unit to for example said printed circuit board and mounting said part at the desired position and to an apparatus for mounting a part at a specific position, in particular mounting an electronic part onto a substrate such as a printed circuit board, comprising first and second head units being at least horizontally movable along first and second axes being perpendicular to each other, first and second part feeding sections being arranged at both sides of said first axis, and a holding mechanism for holding for example said printed circuit board.

A conventional surface mounter (hereinafter simply referred to as the mounter) is known in which small size chip components such as ICs are picked up from a component feeder section with a head unit having a nozzle member for picking up the components, moved over a positioned printed circuit board, and mounted to specified positions on the printed circuit board. In such a mounter, an electric motor-drive mechanism is constituted to move the head unit in the X-Y directions in a horizontal plane.

Recently, mounters have been proposed with higher head movement speed, and a plural number of nozzle members provided on the head unit for higher mounting efficiency while moving a large number of components at a time. The applicant of this invention has also developed a mounter with two head units driven independently of each other from the same viewpoint and applied for a patent (Japanese laid-open patent application 63-178596).

With the mounter of the above-mentioned application, components are mounted to one printed circuit board with the two head units to increase the component mounting efficiency by constituting so that one head unit is mounting a component to the printed circuit board while the other head unit is picking up a component from the component feeding section.

With the above-mentioned mounter with two head units, however, since two head units are moved within the same area, there is a possibility of the moving parts including the head unit interfering with each other. Therefore, with the conventional mounter in which the components are mounted on the printed circuit board held in a fixed position, one head unit may have to wait while the other head unit is working, or the mounting are may be limited. Thus, the two head units are not used efficiently. This has been a negative factor against increasing the mounting efficiency.

Furthermore, while the conventional arrangement tries to avoid interference by means of measures using software, a complicated control system is required to avoid the interference between the head units while increasing the mounting efficiency. Furthermore, measures have to be taken to prevent the head unit interference due to bugs and malfunctions, which deteriorates design efficiency.

US-A-5 203 061 shows an apparatus and a method as defined in the prior art portions of claims 1 and 5.

Accordingly, it is an objective of the present invention to provide an improved method and apparatus for mounting a part at a specific position as indicated above which facilitate a faster mounting velocity by avoiding an interference between moving parts.

According to the invention, this objective is solved for a method as defined in claim 1.

Further, this objective is solved for an apparatus as defined in claims.

Thereby, it is possible that the first and second head units are moved together in the direction of the second axis and independently from each other in the direction of the first axis by means of a common head unit support member.

The mounting velocity may be further enhanced in that each of said first and second head units carries out a recognition step of the picking up respective part to determine the position of the pick up part with respect to the respective first and second head units.

With this surface mounter, the components are mounted to the printed circuit board apparatus for mounting a part or held with the printed circuit board holding member while the support member is moved in the first axis direction and the head units are moved in the second axis direction. During the mounting operation, one head unit mounts the components while the other head unit picks up the components. At this time, the printed circuit board holding member and the printed circuit board move as a whole relative to the head unit which is to carry out component mounting. Therefore, actions of the head units do not restrict each other and carried out in parallel in good order.
Furthermore, mounting areas for the printed circuit board are not restricted.

Furthermore with this surface mounter, interference between moving parts including the head units is physically avoided because two head units are attached to a single support member and the head units are moved on different guide members.

The surface mounter according to another embodiment of the invention is the mounter in which the drive mechanisms for the support members are constituted so that movable zones of the head units and the support members are not common in the first axis direction.

With this surface mounter, interference between the head units and support members is physically prevented because their moving zones are not common.

The surface mounter according to a further embodiment of the invention is a member in which the drive mechanisms for the support members are constituted so that movable zones of the head units and the support members are not common in the first axis direction.

With this surface mounter, a series of actions such as conveying in the printed circuit board, component mounting, and conveying out are carried out with a high efficiency.

Other preferred embodiments of the present invention are laid down in further dependent claims.

In the following, the present invention is explained in greater detail with respect to several embodiments thereof in conjunction with the accompanying drawings, wherein:
FIG. 1 is a schematic plan view of a surface mounter as the first embodiment of this invention;
FIG. 2 is a schematic front view of the surface mounter mentioned above;
FIG. 3 is a schematic side view of the surface mounter mentioned above;
FIG. 4 is a schematic view showing a method of component recognition; and
FIG. 5 is a schematic plan view of another surface mounter.

Embodiments of the invention will be described in reference to the appended drawings.

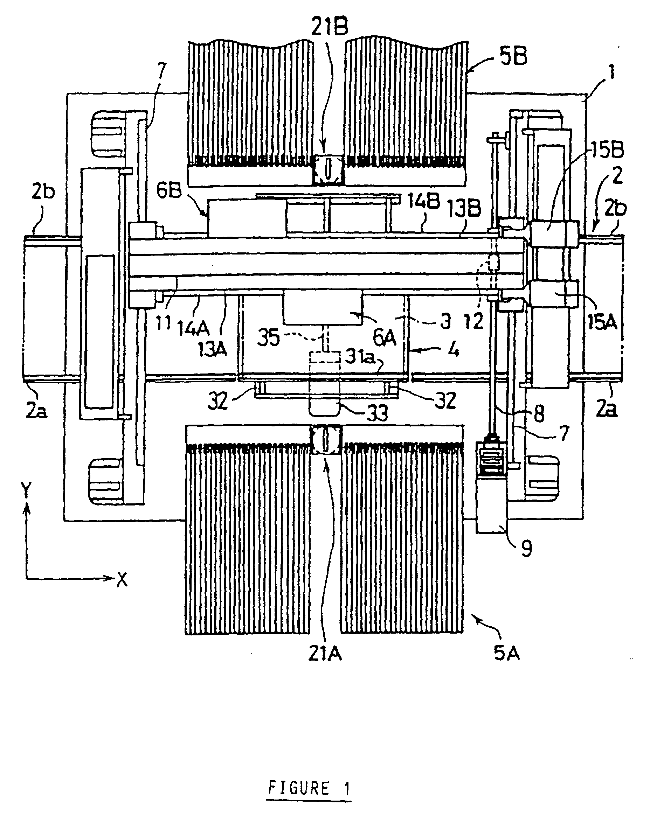

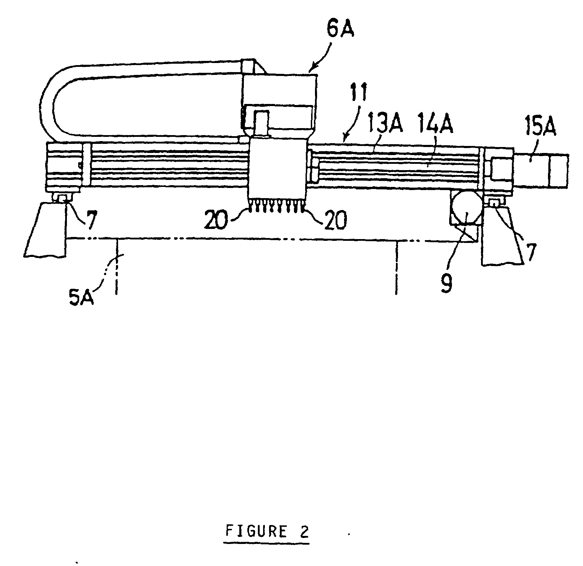

FIGs. 1 through 3 are rough drawings of the first embodiment of the surface mounter of the invention. As shown in the drawings, on the base (1) of a mounter is disposed a conveyor (2) for conveying printed circuit boards so that the printed circuit boards (3) are conveyed along the conveyor (2). The conveyor (2) comprises paired parallel belt conveyors (2a) and (2b). The distance between the two belt conveyors (2a, 2b) may be increased or decreased according to the size of the printed circuit board to be processed. The conveyor (2) is also provided with a printed circuit board holding mechanism (4) which will be described later. When the components are mounted, the printed circuit board (3) is held with the printed circuit board holding mechanism (4).

Component feeding sections (5A) and (5B) are disposed on both sides of the conveyor (2). The component feeding sections (5A) and (5B) are provided with multiple rows of tape feeders. Each of the tape feeders comprises a tape on which small size chip components such as ICs, transistors, capacitors, etc. are held at specified intervals. The tape is reeled out intermittently with a ratchet type feeding mechanism disposed at the tape feed out end as the chip components are picked up with the head unit which will be described later.

A first and a second head unit (6A) and (6B) for mounting components are provided above the base (1). The head units (6A) and (6B) are arranged to be movable in the X-axis direction (in the direction of the conveyor (2) or the first axis direction) and the Y-axis direction (the direction at right angles to the X axis in a horizontal plane). Movements in the X-axis direction are independent of each other while movements in the Y-axis direction occur in a body.

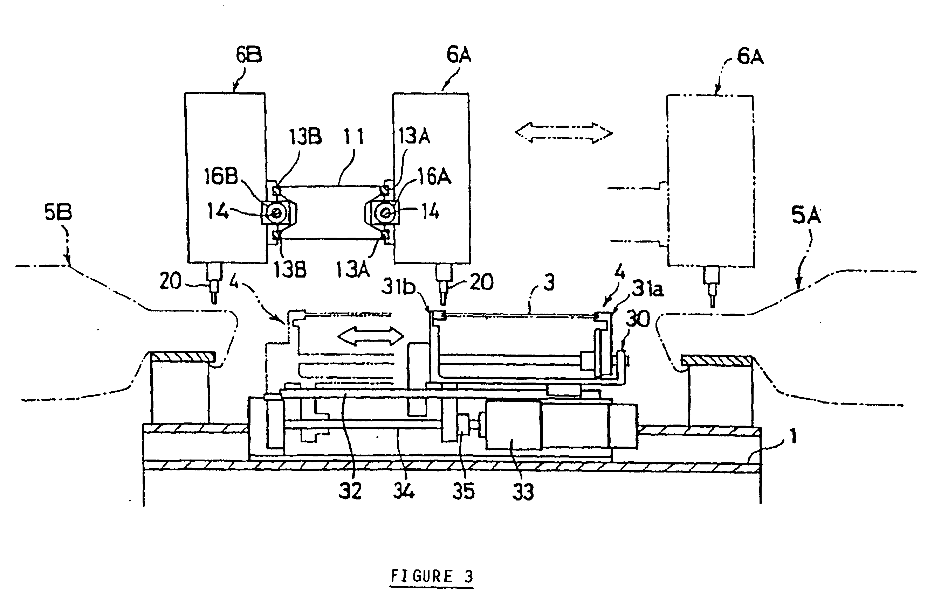

That is to say, above the base (1) are disposed a pair of fixed rails (7) and a ball screw shaft (8) driven with a Y-axis servomotor (9). A head unit support member (11) (hereinafter simply referred to as the support member (11)) is disposed on the fixed rails (7). A nut portion (12) provided on the support member (11) engages with the ball screw shaft (8). On both sides (upper and lower sides in FIG. 1) are disposed parallel guide members (13A) and (13B) extending in the X-axis direction and ball screw shafts (14A) and (14B) driven with X-axis servomotors (15A) and (15B). The head units (6A) and (6B) are movably attached to the guide guide members (13A) and (13B). Nut portions (16A) and (16B) respectively provided on the head unit (6A) and (6B) (shown in FIG. 3) are in screw engagement with the ball screw shafts (14A) and (14B).

As the ball screw shaft (8) is rotated with the Y-axis servomotor (9) and the support member (11) is moved in the Y-axis direction, the head units (6A) and (6B) are moved together in the Y-axis direction. As the ball screw shafts (14A) and (14B) are rotated, head units (6A) and (6B) are moved independently of each other in the X-axis direction relative to the support member (11) in the X-axis direction.

Each of the head units (6A) and (6B) are provided with nozzle members (20) for picking up components. In this embodiment, eight nozzle members (20) are disposed in the X-axis direction. Each nozzle member (20) is operated with a Z-axis servomotor and an R-axis servomotor (not shown) to move up and down (movement in the Z-axis direction) and to rotate about the nozzle center axis (R-axis) relative to a frame for the head units (6A) and (6B). Each nozzle member (20) is connected to negative pressure means (not shown) through a valve so that a specified negative pressure for picking up the chip component is supplied to the nozzle member (20).

The component feeding sections (5A) and (5B) are respectively provided with sensor units (21A) and (21B) for taking the images of the components so as to recognize the state of the components picked up with the nozzle members (20) of the head units (6A) and (6B). The sensor units (21A) and (21B) are disposed in spaces formed as a result of the tape feeders of the component feeding sections (5A) and (5B) being disposed separately on right and left.

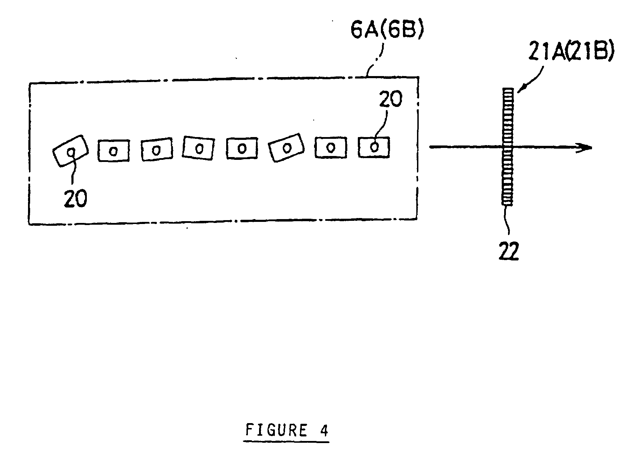

Each of the sensor units (21A) and (21B) comprises as shown in FIG. 4 a line sensor (22) made up of CCD solid-state pickup elements arranged in a row in the Y-axis direction and a large number of LEDs. When the components are mounted, as shown in FIG. 4, the line sensor (22) is moved in the X-axis direction at right angles to the direction of the row of the line sensor (22) (Y-axis direction) at a specified speed to take the images of the components picked up with the nozzle members (20).

As described above, this embodiment is arranged with the head units (6A) and (6B) on both sides of the support member (11) so that the pickup and recognition of a component is carried out with the first head unit (6A) on one side (underside in the drawing) using the component feeding section (5A) and the sensor unit (21A) while the pickup and recognition of another component is carried out with the second head unit (6B) on the other side (topside in the drawing) using the component feeding section (5B) and the sensor unit 21(B).

As shown in FIGs. 1 and 3, the printed circuit board holding mechanism (4) has a frame (30) provided with a pair of belt conveyors (31a) and (31b). The belt conveyors (31a) and (31b), though not shown in detail, are arranged so that their mutual distance is adjustable. Normally, the distance is kept the same as that of the belt conveyors (2a) and (2b) so as to form part of the conveyor (2) and a conveying passage for the printed circuit board (3).

The frame (30) is attached to a pair of guide rails (32) extending in the Y-axis direction between the component feeding sections (5A) and (5B) on the base (1). A nut portion (35) is provided on the underside of the frame (30) and engages with a ball screw shaft (34) driven with a servomotor (33). As the ball screw shaft (34) is rotated with the servomotor (33), the frame (30) moves in the Y-axis direction along the guide rails (32).

As shown with solid lines and phantom lines in FIG. 3, the amount of movement of the frame (30) so that one head unit (6A) can mount the components over the entire range in the Y-axis direction of the printed circuit board (3) while the other head unit 6(B) is picking up components. The amount of movement is set on the basis of the maximum size of the printed circuit boards.

Though not shown, the frame (30) is also provided with clamp members for clamping the printed circuit boards located on the belt conveyors (31a) and (31b). When the components are mounted, the clamp members hold the printed circuit boards (3) in position.

Mounting operation of the mounter constituted as described above will be briefly described.

When the mounting operation is started, a printed circuit board (3) is conveyed in along the conveyor (2), set in a specified position on the printed circuit board holding mechanism (4), and clamped with the clamp members.

Furthermore, while the printed circuit board (3) is being conveyed in, the support member (11) moves to one component feeding section, for instance to the component feeding section (5A), and components are picked up with the nozzle members (20) of the first head unit (6A). After picking up the components, the head unit (6A) moves from one side to the other in the X-axis direction above the sensor unit (21A) to recognize the picked up components.

When the pickup and recognition of the components are finished, the support member (11) is moved to the component feeding section (5A) as shown in FIG. 3 for the pickup and recognition of the components with the second head unit (6B).

When the component pickup operation is started with the second head unit (6B) on one hand, on the other hand the component positioning operation of moving the first head unit (6A) in the X-axis direction and moving the printed circuit board (3) in the Y-axis direction by the operation of the printed circuit board holding mechanism (4) and the operation of rotating and moving up and down the nozzle members (20) are repeated to sequentially mount the components picked up with the nozzle members (20) of the first head unit (6A) onto the printed circuit board (3).

When mounting the components with the first head unit (6A) is finished, the support member (11) is moved to the component feeding section (5A) for picking up the components for mounting with the first head unit (6A). When the component pickup operation is started with the first head unit (6A) on one hand, on the other hand the component positioning operation of moving the second head unit (6B) in the X-axis direction and moving the printed circuit board (3) in the Y-axis direction by the operation of the printed circuit board holding mechanism (4) and the operation of rotating and moving up and down the nozzle members (20) are repeated to sequentially mount the components picked up with the nozzle members (20) of the second head unit 6(B) onto the printed circuit board (3).

After that, mounting the components on the printed circuit board (3) is efficiently carried out in such a way that the mounting and pickup of the components are carried out by turns with the head units (6A) and (6B), and the component mounting operation with one head unit and the component mounting operation with the other head unit are carried out in parallel. When the process with the printed circuit board (3) is finished, the frame (30) is reset to the initial position as shown in FIG. 1 in the printed circuit board holding mechanism (4), and the finished printed circuit board (3) is conveyed out to the next process.

As described above, with the mounter of this embodiment, the printed circuit board holding mechanism (4) is operated to move the printed circuit board (3) in the Y-axis direction to set it in position in the Y-axis direction relative to one head unit which carries out the component mounting over the entire area of the circuit board (3) while the other head unit is picking up the components. As a result, operations with the head units (6A) and (6B) are carried out in parallel without restricting the operations each other.

Unlike the conventional device of this type in which one head unit is waiting while the other head unit is in operation or the mounting area for the printed circuit board is restricted, the head units (6A) and (6B) are efficiently utilized to accomplish the mounting operation with a very high efficiency.

Furthermore with this mounter, since the head units (6A) and (6B) are provided on the same support member (11) so that they move along the separate guide members (13A) and (13B) disposed on both sides of the support member (11), the head units (6A) and (6B) do not interfere with each other during the mounting operation. As a result, unlike the conventional device requiring complicated control system for avoiding the interference between the head units, control system is effectively simplified to enhance design efficiency.

Still another advantage provided by this embodiment is that since the printed circuit board holding mechanism (4) is adapted to constitute part of the conveyor (2), a series of operations such as conveying the printed circuit board in, mounting the components, and conveying the printed circuit board out are carried out efficiently.

As described above, the printed circuit board (3) is positioned by moving it in the Y-axis direction when the components are mounted with this mounter. However, in the case the component pickup operation with one head unit is finished within a shorter time than the time for mounting the components with the other head unit because the component pickup operation with the nozzle members (20) is carried out simultaneously, the mounting operation may be carried out while the support member (11) is being moved in the Y-axis direction.

Next, another mounter as the second embodiment of this invention will be described.

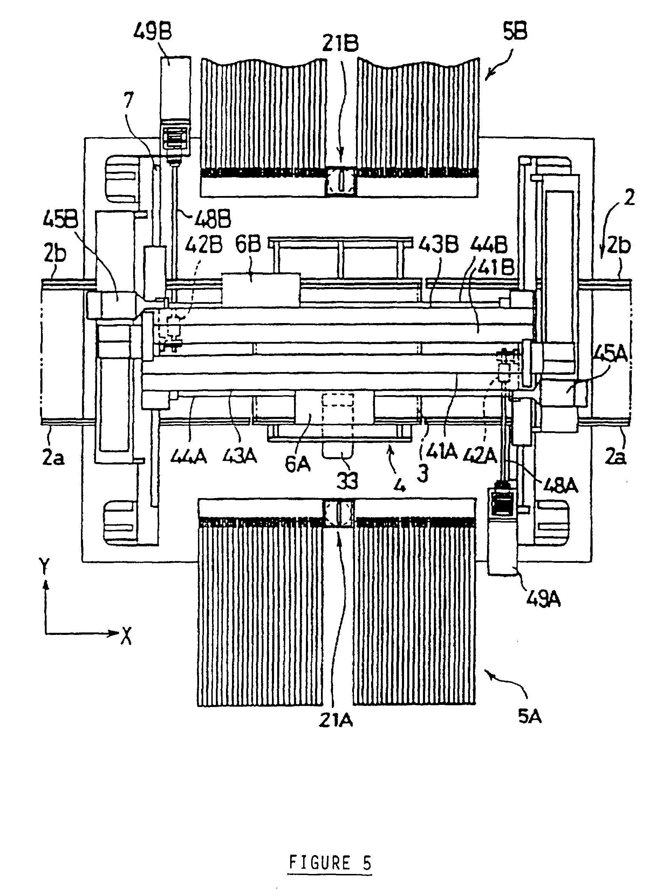

FIG. 5 shows a schematic drawing of another surface mounter. In this mounter, the support and drive structures for the head unit are different from those of the first embodiment. Therefore, the common parts are provided with the same reference symbols, their detailed description is omitted, and only differences will be described.

The first and second head units (6A) and (6B) are movable in the X-axis and Y-axis directions independently of each other.

That is to say, above the base (1) are disposed a pair of fixed rails (7) extending in the Y-axis direction and ball screw shafts (48A) and (48B) respectively disposed by the sides of fixed rails (7) and driven with a first and a second Y-axis servomotors (49A) and (49B). Above them are disposed a first and a second head unit support members (41A) and (41B) (hereinafter simply referred to as the support members (41A) and (41B)). The support members (41A) and 41(B) extend parallel in the X-axis direction with their both ends supported with the paired fixed rails (7). A nut portion (42A) provided on the first support member (41A) engages with one ball screw shaft (48A) while a nut portion (42B) provided on the second support member (41B) engages with the other ball screw shaft (48B). The first support member (41A) is provided with an X-axis direction guide member (43A) and a ball screw shaft (44A) driven for rotation by means of a first X-axis servomotor (45A). Likewise, the second support member (41B) is provided with an X-axis direction guide member (43B) and a ball screw shaft (44B) driven for rotation by means of a first X-axis servomotor (45B). Thus, the head units (6A) and (6B) are movably supported on the guide members (43A) and (43B) with nut portions (not shown) provided respectively on the head units (6A) and (6B) engage with the ball screw shafts (44A) and (44B).

The first support member (41A) is moved in the Y-axis direction by the operation of the first Y-axis servomotor (49A). At the same time, the first head unit (6A) is moved by the operation of the first X-axis servomotor (45A) in the X-axis direction relative to the first support member (41A). On the other hand, the second support member (41B) is moved by the operation of the second Y-axis servomotor (49B). At the same time the second head unit (6B) is moved by the operation of the second X-axis servomotor (45B) in the X-axis direction.

The ball screw shafts (48A) and (48B) are dimensioned to the distance from the sides to the approximate centers of the component feeding sections (5A) and (5B) and therefore the support members (41A) and (41B) can move without interfering with each other within respective zones formed by roughly dividing the area between the component feeding sections (5A) and (5B) into two in the Y-axis direction. As shown in the same drawing, the head units (6A) and (6B) are disposed outer sides, or upper and lower sides, of the support members (41A) and (41B). During the mounting operation, pickup and recognition of the components with the first head unit (6A) are carried out with the component feeding section (5A) and the sensor unit (21A) on one side (underside in the drawing) while pickup and recognition of the components with the second head unit (6B) are carried out with the component feeding section (5B) and the sensor unit (21B) on the other side (top side in the drawing).

Furthermore with the printed circuit board holding mechanism (4), the amount of movement of the frame (30) in the Y-axis direction is set so that almost entire printed circuit board (3) held is disposed within the movable zones of the head units (6A) and (6B).

Next, the mounting operation of the mounter of the constitution described above will be described.

When the mounting operation is started with the mounter, the head units (6A) and (6B) move to the component feeding sections (5A) and (5B), and components are picked up with the nozzle members (20). In the meantime, the printed circuit board (3) on the conveyor (2) is conveyed in and set in position and held on the printed circuit board holding mechanism (4).

When the pickup of the components is finished, the head unit which carries out component mounting first, for example the first head unit (6A) is moved from one side to the other of the X-axis direction above the sensor unit (21A) so that the components are recognized. In the meantime, the printed circuit board holding mechanism (4) is operated, and the printed circuit board (3) is set to a specified working position in the movable zone of the head unit (6A).

While the movement of the first head unit (6A) in the X-axis direction, movement of the support member (41A) in the Y-axis direction, and the up and down movement and rotation of the nozzle members (20) are repeated, the components picked up with the nozzle members (20) are mounted sequentially to the printed circuit board (3).

When the component mounting is finished with the first head unit (6A), the printed circuit board holding mechanism (4) is operated, and the printed circuit board (3) is set to a specified working position in the movable zone of the head unit (6B). At the same time, the second head unit (6B) is moved from one side to the other of the X-axis direction above the sensor unit (21B) so that the components are recognized.

After the components are recognized, the movement of the second head unit (6B) in the X-axis direction, movement of the support member (41B) in the Y-axis direction, and the up and down movement and rotation of the nozzle members (20) are repeated, and the components picked up with the nozzle members (20) are mounted sequentially to the printed circuit board (3).

While the component mounting is carried out with the second head unit (6B), the first head unit (6A) which has carried out the component mounting first is moved to the component feeding section (5A) so that the components to be mounted next are picked up. After the pickup, the components are recognized.

When the component mounting with the second head unit (6B) is finished, the component mounting operation is started with the first head unit (6A). At the same time, the second head unit (6B) moves to the component feeding section to pick up the components to be mounted next. After that, mounting the components on the printed circuit board (3) is efficiently carried out in such a way that the mounting and pickup of the components are carried out by turns with the head units (6A) and (6B), and the component mounting operation with one head unit and the component mounting operation with the other head unit are carried out in parallel.

With the mounter described above, since the head units (6A) and (6B) are disposed at separate support members (41A) and (41B) and the support members (41A) and (41B) are disposed in the zones formed by roughly dividing the area between the component feeding sections (5A) and (5B) into two in the Y-axis direction, there is no interference between the head units (6A) and (6B), and the support members (41A) and (41B). As a result, like the mounter of the first embodiment, complicated control system for avoiding the interference between the head units is unnecessary.

Furthermore as described above, because the printed circuit board (3) is moved in the Y-axis direction and positioned in the movable zones of the head units (6A) and (6B) when the components are to be mounted, the components may be mounted over the entire area of the printed circuit board (3) by means of the head units (6A) and (6B) in spite of the structure in which the working area is divided into two for the head units (6A) and (6B). As a result, also with this mounter, highly efficient component mounting is carried out using the two head units (6A) and (6B).

In addition to mounting the components to the printed circuit board (3) positioned to specified positions in the movable zones of the head units (6A) and (6B), the components may also be mounted, for example, while moving both the component mounting head unit and the printed circuit board (3) in the Y-axis direction to farther enhance the component mounting efficiency.

By the way, the embodiments described above are part of examples of the surface mounter and therefore their specific constitutions and control may be appropriately modified within the scope of the invention as defined by the claims.

For example, while in the mounters, the sensor units (21A) and (21B) are disposed in the component feeding sections (5A) and (5B), and the component recognition is carried out by relative movements of the head units (6A) and (6B) above the sensor units (21A) and (21B), the head units (6A) and (6B) may be provided with component recognition devices using laser beams. Such an arrangement can farther improve the mounting efficiency because the picked up components are recognized in the middle of the movement of the head units (6A) and (6B) from the component feeding sections (5A) and (5B) to the component mounting positions.

Furthermore with the surface mounter shown in Fig. 5, while the movable zones of the support members (41A) and (41B) are separated into two in the Y-axis direction, the drive mechanism for the support members (41A) and (41B) may be constituted so that the movable zones of the support members (41A) and (41B) are common. Specifically, it may be arranged that the ball screw shafts (48A) and (48B) are extended in the Y-axis direction so that the support members (41A) and (41B) may move respectively over the entire range between the component feeding sections (5A) and (5B). With such an arrangement, the movable ranges of the support members (41A) and (41B) are enlarged. This in turn may reduce the amount of movement, required of the printed circuit board holding mechanism (4), of the printed circuit board (3). Such an arrangement becomes effective when the movement space for the printed circuit board (3) in the Y-axis direction cannot be secured enough because of the layout of the mounter component.

As described above, the surface mounter according to an embodiment of the invention is constituted with two head units attached to the support member movable in the first axis direction so that the head units may be moved in the second axis direction which is at right angles to the first axis direction. The printed circuit board holding member capable moving in the first axis direction is provided for holding the printed circuit board. With such a constitution, during the component mounting operation, the printed circuit board is moved relative to the head unit which mount the components onto the printed circuit board. Therefore, operations of respective head units do not restrict each other and the operations are carried out in parallel. As a result, the head units are utilized efficiently to accomplish efficient mounting operation. Furthermore, since the head units are arranged to move along separate guide members of the same support member, there is no possibility of the head units interfering with each other during the mounting operation. As a result, the control system is effectively simplified to enhance design efficiency.

The surface mounter according to another embodiment of the invention is constituted with two support members capable of moving in the first axis direction and respectively supporting head units. The head units are respectively moved along the guide members in the second axis direction which is at right angles to the first axis direction. The printed circuit board is held with the printed circuit board holding member capable of moving in the first axis direction. The component mounting operation is carried out while the printed circuit board is being moved relative to the head unit which performs the component mounting. With such a constitution, like the surface mounter of claim 1, the head units are utilized efficiently to accomplish efficient mounting operation. In the case of this surface mounter in particular, interference between the head units and the support members is physically avoided by constituting the drive mechanism for the support members so that the movable zones for the head units and the support members in the Y-axis direction are not common. As a result, the control system is effectively simplified to enhance design efficiency.

Furthermore, by providing the printed circuit board conveying passage for conveying the printed circuit board in and out from the work areas so that the printed circuit board conveying passage forms part of the printed circuit board conveying passage, a series of actions such as conveying the printed circuit board in and out from the work areas and the component mounting are carried out with an improved efficiency.

## Claims

1. Method of mounting a part at a specific position, in particular, mounting an electronic part onto a substrate such as a printed circuit board (3) with an apparatus, said apparatus comprising first and second head units (6A, 6B) being at least horizontally movable along first and second axes (X-, Y-axis) being perpendicular to each other wherein the first and second head units (6A, 6B) are provided on both sides of the first axis (X-axis), first and second part feeding sections (5A, 58) being arranged at both sides of said first axis (X-axis), and a holding mechanism (4) for holding the substrate (3), comprising the steps of moving the respective head units (6A, 6B) to the respective part feeding section (5A, 58), picking up the part to be mounted, moving the respective head unit (6A, 6B) to the substrate and mounting said part at the desired position, wherein when one of said first and second head units (6A, 6B) picks up a part the other of said first and second head units (6A, 6B) mounts another part and vice versa, **characterized in that** said first and second head units (6A, 6B) are moved together in the direction of said second axis (Y-axis) and independently from each other in the direction of the first axis (X-axis).

2. Method according to claim 1, **characterized in that** said first and second head units (6A, 6B) are only horizontally movable within moving areas provided at both sides of said first axis (X-axis).

3. Method according to claims 1 or 2, **characterized in that** said each of said first and second head units (6A, 6B) carries out a recognition step after picking up a respective part to determine the position of the picked up part with respect to the respective first and second head units (6A, 6B).

4. Method according to at least one of the preceding claims 1 to 3, **characterized in that** said holding mechanism (4) is moved in the direction of said second axis (Y-axis) to position the holding mechanism (4) relative to the one of said first and second head units (6A, 6B) which carries out the component mounting.

5. Apparatus for mounting a part at a specific position, in particular mounting an electronic part onto a substrate such as a printed circuit board (3), comprising first and second head units (6A, 6B) being at least horizontally movable along first and second axes (X-, Y-axis) being perpendicular to each other, wherein the first and second head units (6A, 6B) are provided on both sides of the first axis (X-axis), first and second part feeding sections (5A, 5B) being arranged at both sides of said first axis (X-axis), a holding mechanism (4) for holding the substrate (3), and a means (11; 41A, 41B) for supporting said first and second head units (6A, 6B) such that one of the first and second head units (6A, 6B) picks up a part and simultaneously the other of the first and second head unit (6A, 6B) mounts another part and vice versa, **characterized in that** said means comprises a head unit support member (11) movable along said second axis (Y-axis) and supporting said first and second head units (6A, 6B) such that they are independently movable along said first axis (X-axis).

6. Apparatus according to claim 5, **characterized in that** said first and second head units (6A, 6B) are horizontally movable only within moving areas provided at both sides of said first axis (X-axis).

7. Apparatus according to claim 5 or 6, **characterized in that** said each of said first and second head units (6A, 6B) is adapted to carry out a recognition after picking up a respective part to determine the position of the picked up part with respect to the respective first and second head units (6A, 6B), respectively.

8. Apparatus according to one of the preceding claims 5 to 7, **characterized in that** said holding mechanism (4) is movable in the direction of said second axis (Y-axis) to position the holding mechanism (4) relative to the one of said first and second head units (6A, 6B) which carries out the component mounting.

## Patentansprüche

1. Verfahren zum Montieren eines Teiles an einer bestimmten Position, insbesondere Montieren eines elektronischen Teiles auf einem Substrat, wie z. B. einer gedruckten Leiterplatte (3) mit einer Vorrichtung, wobei die Vorrichtung eine erste und zweite Kopfeinheit (6A, 6B) aufweist, die entlang erster und zweiter Achsen (X- Achse, Y- Achse), die zueinander senkrecht sind, zumindest horizontal bewegbar sind, wobei die erste und zweite Kopfeinheit (6A, 6B) auf beiden Seiten der ersten Achse (X- Achse) vorgesehen sind, erste und zweite Teile- Zuführabschnitte (5A, 5B) auf beiden Seiten der ersten Achse (X- Achse) angeordnet sind, und eine Haltevorrichtung (4) zum Halten des Substrats (3), mit den Schritten des Bewegens der jeweiligen Kopfeinheit (6A, 6B) zu dem jeweiligen Teile- Zuführabschnitt (5A, 5B), Aufnehmen des zu montierenden Teiles, Bewegen der jeweiligen Kopfeinheit (6A, 6B) zu dem Substrat und Montieren des Teiles an der vorbeschriebenen Position, wobei dann, wenn eine der ersten oder zweiten Kopfeinheiten (6A, 6B) ein Teil aufnimmt, die andere der ersten oder zweiten Kopfeinheiten (6A, 6B) ein weiteres Teil montiert, und umgekehrt, **dadurch gekennzeichnet, dass** die ersten und zweiten Kopfeinheit (6A, 6B) gemeinsam in die Richtung der zweiten Achse (Y- Achse) und voneinander unabhängig in die Richtung der ersten Achse (X- Achse) bewegt werden.

2. Verfahren nach Anspruch 1, **dadurch gekennzeichnet, dass** die erste und zweite Kopfeinheiten (6A, 6B) nur innerhalb der Bewegungsbereiche, vorgesehen auf beiden Seiten der ersten Achse (X- Achse), horizontal bewegbar sind.

3. Verfahren nach Anspruch 1 oder 2, **dadurch gekennzeichnet, dass** jede der ersten und zweiten Kopfeinheiten (6A, 6B) einen Erkennungsschritt nach dem Aufnehmen eines jeweiligen Teiles ausführt, um die Position des aufgenommenen Teiles in Bezug auf die erste und zweite Kopfeinheit (6A, 6B) zu bestimmen.

4. Verfahren nach zumindest einem der vorhergehenden Ansprüche 1 bis 3, **dadurch gekennzeichnet, dass** die Haltevorrichtung (4) in die Richtung der zweiten Achse (Y- Achse) bewegt wird, um die Haltevorrichtung (4) in Bezug zu der einen der ersten oder zweiten Kopfeinheit (6A, 6B) zu positionieren, die das Montieren der Bauteile ausführt.

5. Vorrichtung zum Montieren eines Teiles an einer bestimmten Position, insbesondere Montieren eines elektronischen Teiles auf einem Substrat, wie z. B. einer gedruckten Leitungsplatte (3), mit einer ersten und zweiten Kopfeinheit (6A, 6B), die entlang erster und zweiter Achsen (X- Achse, Y- Achse), die zueinander senkrecht sind, zumindest horizontal bewegbar sind, wobei die erste und zweite Kopfeinheit (6A, 6B) auf beiden Seiten der ersten Achse (X- Achse) vorgesehen sind, erste und zweite Teile- Zuführabschnitte (5A, 5B) auf beiden Seiten der ersten Achse (X- Achse) angeordnet sind, eine Haltevorrichtung (4) zum Halten des Substrats (3), und eine Einrichtung (11; 41A, 41B) zum Lagern der ersten und zweiten Kopfeinheit (6A, 6B) angeordnet ist, derart, dass die erste oder zweite Kopfeinheit (6A, 6B) ein Teil aufnimmt und die andere erste oder zweite Kopfeinheit (6A, 6B) ein weiteres Teil montiert, oder umgekehrt, **dadurch gekennzeichnet, dass** die Einrichtung ein Kopfeinheit- Lagerteil (11) aufweist, bewegbar entlang der zweiten Achse (Y- Achse), und das die erste und zweite Kopfeinheit (6A, 6B) derart lagert, dass sie entlang der ersten Achse (X- Achse) unabhängig bewegbar sind.

6. Vorrichtung nach Anspruch 5, **dadurch gekennzeichnet, dass** die erste und zweite Kopfeinheit (6A, 6B) nur innerhalb von Bewegungsbereichen, vorgesehen auf beiden Seiten der ersten Achse (X- Achse), horizontal bewegbar sind.

7. Vorrichtung nach Anspruch 5 oder 6, **dadurch gekennzeichnet, dass** jede der ersten oder zweiten Kopfeinheiten (6A, 6B) vorgesehen ist, nach dem Aufnehmen eines jeweiligen Teiles eine Erkennung auszuführen, um jeweils die Position des aufgenommenen Teiles in Bezug zu der jeweiligen ersten oder zweiten Kopfeinheit (6A, 6B) zu bestimmen.

8. Vorrichtung nach einem der vorhergehenden Ansprüche 5 bis 7, **dadurch gekennzeichnet, dass** die Haltevorrichtung (4) in der Richtung der zweiten Achse (Y- Achse) bewegbar ist, um die Haltevorrichtung (4) in Bezug zu der einen der ersten oder zweiten Kopfeinheiten (6A, 6B) zu positionieren, die die Montage des Bauteiles ausführt.

## Revendications

1. Procédé pour monter un composant à une position spécifique, en particulier, pour monter un composant électronique sur un substrat tel qu'une carte à circuit imprimé (3) à l'aide d'un dispositif, ledit dispositif comprenant des première et seconde unités de tête (6A, 6B) qui sont, au moins horizontalement, mobiles le long de premier et second axes (axe X, axe Y) perpendiculaires l'un à l'autre, dans lequel les première et seconde unités de tête (6A, 6B) sont disposées sur les deux côtés du premier axe (axe X), des première et seconde sections d'amenée (5A, 5B) étant agencées aux deux côtés dudit premier axe (axe X), et un mécanisme de maintien (4) pour maintenir le substrat (3), comprenant les étapes consistant à déplacer les unités de tête respectives (6A, 6B) à la section d'amenée de composant respective (5A, 5B), à recueillir le composant devant être monté, à déplacer l'unité de tête respective (6A, 6B) au substrat et à monter ledit composant à la position désirée, dans lequel, lorsque l'une desdites première et seconde unités de tête (6A, 6B) recueille un composant, l'autre desdites première et seconde unités de tête (6A, 6B) monte un autre composant et vice-versa, **caractérisé en ce que** lesdites première et seconde unités de tête (6A, 6B) sont déplacées conjointement suivant la direction dudit second axe (axe Y), et indépendamment l'une de l'autre suivant la direction du premier axe (axe X).

2. Procédé selon la revendication 1, **caractérisé en ce que** lesdites première et seconde unités de tête (6A, 6B) sont horizontalement mobiles, uniquement au sein de zones de mobilité disposées aux deux côtés dudit premier axe (axe X).

3. Procédé selon la revendication 1 ou 2, **caractérisé en ce que** chacune desdites première et seconde unités de tête (6A, 6B) accomplit une étape de reconnaissance après avoir recueilli un composant respectif, afin de déterminer la position du composant recueilli par rapport aux première et seconde unités de tête respectives (6A, 6B).

4. Procédé selon au moins l'une des rev endications précédentes 1 à 3, **caractérisé en ce que** ledit mécanisme de maintien (4) est déplacé suivant la direction dudit second axe (axe Y), afin de positionner le mécanisme de maintien (4) par rapport à l'une desdites première et seconde unités de tête (6A, 6B) qui accomplit le montage du composant.

5. Dispositif pour monter un composant à une position spécifique, en particulier, pour monter un composant électronique sur un substrat tel qu'une carte à circuit imprimé (3), comprenant des première et seconde unités de tête (6A, 6B) qui sont, au moins horizontalement, mobiles le long de premier et second axes (axe X, axe Y) perpendiculaires l'un à l'autre, dans lequel les première et seconde unités de tête (6A, 6B) sont disposées sur les deux côtés du premier axe (axe X), des première et seconde sections d'amenée (5A, 5B) étant agencées aux deux côtés dudit premier axe (axe X), et un mécanisme de maintien (4) pour maintenir le substrat (3), et un moyen (11 ; 41A, 41B) pour supporter lesdites première et seconde unités de tête (6A, 6B), de telle sorte que l'une des première et seconde unités de tête (6A, 6B) recueille un composant et que, simultanément, l'autre des première et seconde unités de tête (6A, 6B) monte un autre composant et vice-versa, **caractérisé en ce que** ledit moyen comprend un élément de support d'unités de tête (11) mobile le long dudit second axe (axe Y) et supportant lesdites première et seconde unités de tête (6A, 6B) de telle sorte qu'elles soient indépendamment mobiles le long dudit premier axe (axe X).

6. Dispositif selon la revendication 5, **caractérisé en ce que** lesdites première et seconde unités de tête (6A, 6B) sont horizontalement mobiles, uniquement au sein de zones de mobilité disposées aux deux côtés dudit premier axe (axe X).

7. Dispositif selon la revendication 5 ou 6, **caractérisé en ce que** chacune desdites première et seconde unités de tête (6A, 6B) est conçue pour accomplir une étape de reconnaissance après avoir recueilli un composant respectif, afin de déterminer la position du composant recueilli par rapport aux première et seconde unités de tête respectives (6A, 6B), respectivement.

8. Dispositif selon l'une des revendications précédentes 5 à 7, **caractérisé en ce que** ledit mécanisme de maintien (4) est mobile suivant la direction dudit second axe (axe Y), afin de positionner le mécanisme de maintien (4) par rapport à l'une desdites première et seconde unités de tête (6A, 6B) qui accomplit le montage du composant.
